# EUROPEAN PATENT SPECIFICATION

(11) **EP 0 632 484 B1**
(45) Date of publication and mention of the grant of the patent: **23.10.1996**
(21) Application number: 93830283.3
(22) Date of filing: 30.06.1993
(51) Int. Cl.: H01L 21/00, B23K 20/00

(54) **Method and apparatus for connecting wires between a semiconductor chip and corresponding pins**
Verfahren und Vorrichtung, um Drähte zwischen einem Halbleiterchip und dem zugehörigen Leiterrahmen anzuschliessen
Procédé et dispositif pour connecter des fils conducteurs entre une puce semiconductrice et le cadre correspondant

(43) Date of publication of application: 04.01.1995
(73) Proprietor: SGS-THOMSON MICROELECTRONICS S.r.l., I-20041 Agrate Brianza (Milano) (IT); CO.RI.M.ME. CONSORZIO PER LA RICERCA SULLA MICROELETTRONICA NEL MEZZOGIORNO, I-95121 Catania (IT)
(72) Inventor: Grasso, Antonio, I-95030 Gravina di Catania (CT) (IT); Pinto, Antonio, I-95128 Catania (IT)
(74) Representative: Checcacci, Giorgio

(56) References cited:
- GB-A- 2 177 639
- US-A- 3 218 702
- PATENT ABSTRACTS OF JAPAN vol. 6, no. 111 (E-114) (989) 22 June 1982 & JP-A-57 040 948

## Description

### Field of the Invention

This invention relates to a method for connecting wire leads between a semiconductor circuit chip and corresponding terminal connectors.

The invention also concerns an improved tool head for implementing the method on stitch bonding equipment.

### Background Art

As is well known, in the specific field of this invention, there exists a need to establish electrical connections between a semiconductor circuit chip and corresponding pins or rheophores on a supporting metal frame.

The connecting pins are formed integrally with the frame and allow the semiconductor circuit to be mounted on and connected to a pre-printed electronic board.

Provided on the semiconductor chip periphery are predetermined contact pads whereto the terminations of the circuit structure are led; thin wires are connected between said pads and the inward ends of the corresponding pins.

This process step of providing the electrical connections between the semiconductor chip and the corresponding pins is obviously critical.

In fact, at this stage of the semiconductor circuit manufacturing process, a chip has already passed an electric test checking the proper operation of its circuitry.

Therefore, should the wire connections be performed in anything less than a workmanlike fashion, there would be a material risk that the circuit is unable to operate correctly and that it is rejected.

An even more undesirable and dangerous event is that the device is initially found in proper working condition, but it fails to operate after some time of use.

The importance of having the wire connection bonding carried out in a truly reliable manner is, therefore, self-evident.

To this aim, some special equipment such as the stitch bonding machines have been developed. Each machine includes at its tooling end a bonding tool head driven automatically toward and away from a silicon chip mounted on a central portion of the frame.

An apparatus for bonding wires to metal surfaces is described in the US Patent No. 3,218,702 of November 23, 1965. Such an apparatus relates to the pressure bonding or welding of metal elements, particularly to the bonding of fine wires formed of precious metals to small metallic areas on transistors, and comprises a bonding tool having a groove for receiving the wire during the bonding operation. The tool of this known bonding apparatus makes bonds of identical area.

Furthermore, the GB Patent No. 2 177 639 of July 8, 1985 describes an improved ultrasonic wire bonder which can perform the simultaneous bonding of two connecting wires, still of identical bonding areas.

Moreover, the JP Patent No.57-40948 of March 6, 1982 details a wire bonding method for semiconductor devices, providing planar bonding wedges, formed at double heads having different bonding areas.

While achieving its basic objective, such conventional equipments aren't yet attaining a sufficient reliability level to ensure faultless bonding of the wires.

Furthermore, the trend of today's technologies favors increased miniaturization on the chip, which still further reduces the area available for bonded wire connections.

The underlying technical problem of this invention is to provide a method for improving the quality of the connections between a semiconductor circuit chip and the pins of its supporting frame, which method has such functional features as to overcome the limitations investing the prior art solutions.

### Summary of the Invention

The solutive idea on which this invention is based start from the simple postulate that, to enhance the quality and effectiveness of a bonded connection, the bonding area must be enlarged.

Based on this solutive idea, the technical problem is solved by a wire bonding method of the kind outlined above and as defined in the characterizing parts of Claims 1 to 3.

This technical problem is also solved by a tool head for stitch bonding equipment, as defined in Claim 4 and following.

The features and advantages of the method according to this invention will become apparent from the following description of an embodiment thereof, given by way of illustration and not of limitation with reference to the accompanying drawings.

### Brief Description of the Drawings

In the drawings:
- Figure 1 shows, partly in cross-section, a schematic view of a semiconductor material chip mounted on a supporting frame and undergoing a wire bonding process according to the inventive method;
- Figure 2 is a schematic view of a tool head, according to the invention, as applied to stitch bonding equipment for implementing the process of Figure 1;
- Figure 3 is a vertical section view, taken along line III-III through the tool shown in Figure 2;
- Figure 4 is a further vertical section view of the tool shown in Figure 2, taken along line IV-IV; and
- Figure 5 is an enlarged scale detail view of Figure 3.

### Detailed Description

With reference to the drawing views, generally and schematically shown at 1 is a chip of a semiconductor material, such as silicon, on which an electronic circuit, not shown because conventional, has been realized.

The chip 1 is supported on and bonded to a central portion 3 of a frame 2 formed by a thin metal sheet.

Understandably, the chip 1 and frame 2 would contact each other along the surface 4 of the semiconductor substrate, while the circuit would be in full view on the exposed surface of the chip.

The frame 2 is formed integrally with plural connection terminals consisting substantially of contact pins 5 which, completing the manufacturing process, may be plugged on a pre-printed electronic board.

A wire lead 7 is bonded between each of said pins 5 and a corresponding contact pad on the chip 1. Specifically, the wire is bonded to an inward end or post lead 8 of the pin 5 and to a pad 6 on the chip.

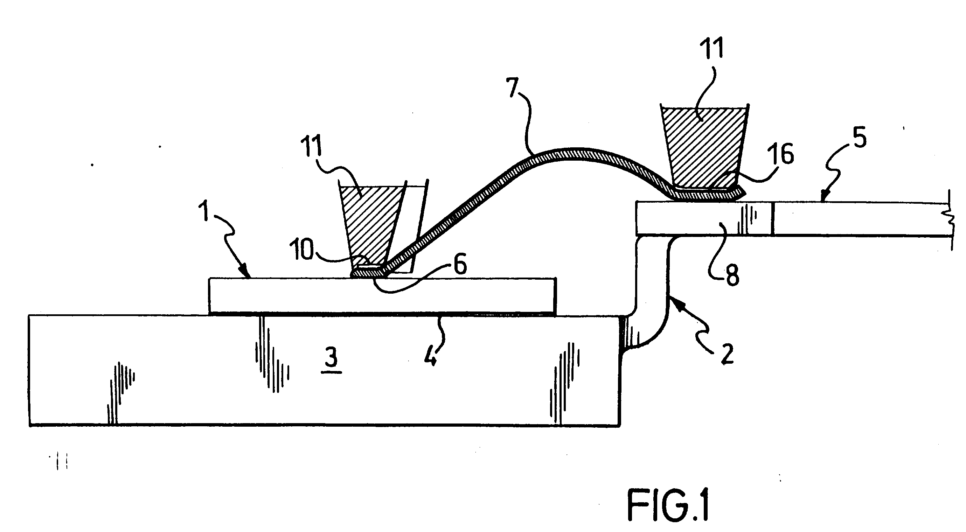

Shown by way of example in Figure 1 is a wire 7 elongated between the post lead 8 of a pin 5 and a contact pad 6 located peripherally on the chip 1.

The opposite ends of the wire 7 are, therefore, bonded to the end 8 of the pin 5 and to the connection pad 6, respectively.

For this purpose, a stich bonding type of equipment, only partially shown, is provided. This equipment carries at its working end a bonding tool head 9 which can be driven automatically toward and away from the silicon chip 1 mounted on the frame 2, as well as to and from the pins 5.

Specifically, the tool 9 comprises a bonding tip 11 adapted to abut both against one end of a wire 7 to be bonded to the pad 6 and to the other end of the wire 7 to be bonded to the pin 5.

Advantageously, according to the invention, the tip 11 has a grooved bottom end 12 through which the connecting wire is run.

More particularly, a pair of parallel grooves 13, 14 extend along that end 12. The grooves 13, 14 are substantially V-shaped in cross-section, with a flare angle of approximately sixty degrees.

In addition, the grooves 13, 14 have different lengths. Preferably, and contingent on individual requirements, the first-mentioned groove 13 is about one third to one half longer than the second-mentioned groove 14.

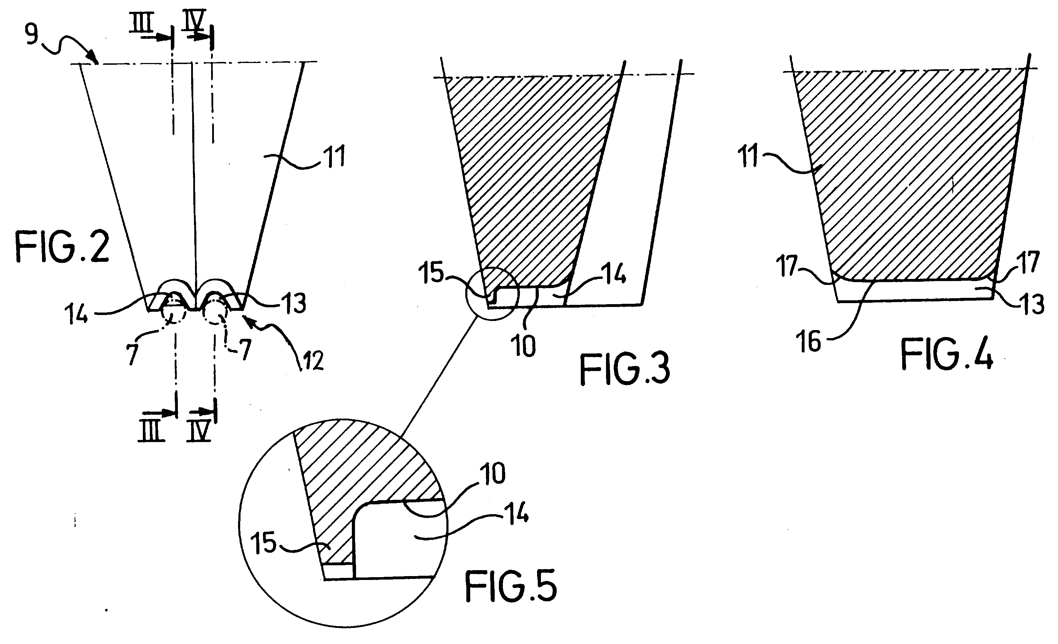

The first groove 13 has a substantially straight-line profile shape with curved opposite ends 17, as shown in Figure 4.

The second groove 14 is instead closed at one end by a projecting pip 15. The profile shape 10 of this second groove 14 is clearly shown in Figure 3. The curved profile between the pip 15 and the line 10 the groove 14 is shown in Figure 5.

The bonding method of this invention will now be described.

While the wire is being bonded to the end 8 of the pin 5, it is held in the first groove 13, as shown on the right in Figure 1.

Bonding is performed with the aid of ultrasound, or using another equivalent technique.

Thereafter, the bonding equipment is operated automatically to bring the tip 11 to a pad 6 on the chip 1 whereto the other end of the wire 7 will be bonded.

However, the wire end is presently held in the second groove 14 while being bonded, all this being shown on the left side of Figure 1.

During this step of the bonding process, the pip 15 will indent and penetrate the wire 7 to weaken its cross-section, but this does not harm the bonded joint, even upon the wire being parted by a sharp pull as is customarily applied to thin wires.

The method and apparatus according to the invention do solve the technical problem and afford several advantages, outstanding among which is surely the fact that the bonded wire connections are more effective and reliable than those to be obtained with prior art techniques.

The differential groove tool, in fact, produces bonded connections to pads and pins which are appropriate for the space and dimensions available at the respective points of contact.

## Claims

1. A method of connecting wire leads (7) between a semiconductor circuit chip (1) and corresponding terminal connectors (5) comprising the following steps:
providing a bonding head (9) comprising a bonding tip (11) having a working end (12)
including at least a pair of different length grooves (13,14), defining at least first and second bonding surfaces with different areas and receiving said wire leads (7);
- holding one end of the wire (7) on the connector (5) in one (13) of said grooves and bonding it;
- holding the other end of said wire on the chip (1) in the other (14) of said grooves and bonding it; and
- indenting said other end of the wire (7) by means of a projection (15) closing one end of the other (14) of said grooves to facilitate breaking of the wire after bonding.

2. A method according to Claim 1, characterized in that said one groove (13) is longer than said other groove (14).

3. A bonding head for equipment operated in a stitch bonding mode to bond wire leads (7) elongated between a semiconductor circuit chip (1) and corresponding terminal connectors (5), comprising a bonding tip (11) having a working end (12) including at least a first and a second bonding surfaces having different areas, characterized in that said bonding tip (11) comprises at least a first (13) and a second wire-holding groove (14) having different lengths and defining said first and second bonding surfaces, the second wire-holding groove (14) being closed at one end by a projection (15) to indent said wire and facilitate breaking of the wire after bonding.

4. A tool head according to Claim 3, characterized in that said grooves (13,14) lie mutually parallel along said working end (12).

5. A tool head according to Claim 3, characterized in that the first (13) of said grooves is approximately one third to one half longer than the second (14) of said grooves.

6. A tool head according to Claim 3, characterized in that said grooves (13,14) are substantially V-shaped with a flare angle of about sixty degrees in a cross-section perpendicular to the length of the grooves.

7. A tool head according to Claim 3, characterized in that the first groove (13) has a substantially straight-line profile shape (16) with curved opposite ends (17), said opposite ends (17) having a curvature pointed toward the center of the bonding tip (11) in a cross-section parallel to the length of the groove.

## Patentansprüche

1. Verfahren zum Verbinden von Leitungsdrähten (7) zwischen einem Halbleiterschaltungschip (1) und entsprechenden Anschlußverbindern (5), umfassend die folgenden Schritte:
- Bereitstellen eines Bondkopfs, der eine Bondspitze (11) mit einem Arbeitsende (12) aufweist, die mindestens ein Paar Nuten (13, 14) unterschiedlicher Länge enthält, welche mindestens eine erste und eine zweite Bondfläche mit verschiedenen Flächengrößen definieren und die Leitungsdrähte (7) aufnehmen;
- Halten eines Endes des Drahts (7) an dem Verbinder (5) in einer (13) der Nuten und Bonden des Endes;
- Halten des anderen Endes des Drahts an dem Chip (1) in der anderen (14) der Nuten und Bonden des Endes; und
- Einkerben des anderen Endes des Drahts (7) mit Hilfe eines Vorsprungs (15), welcher ein Ende der anderen (14) der Nuten verschließt, um das Abbrechen des Drahts nach dem Bonden zu erleichtern.

2. Verfahren nach Anspruch 1,
**dadurch gekennzeichnet**, daß die eine Nut (13) länger als die andere Nut (14) ist.

3. Bondkopf für eine Heftbondanlage zum Bonden von längsgestreckten Leitungsdrähten (7) zwischen einem HalbleiterschaltungsChip (1) und entsprechenden Anschlußverbindern (5), umfassend eine Bondspitze (11) mit einem Arbeitsende (12), welches mindestens eine erste und eine zweite Bondfläche mit unterschiedlichen Flächengrößen aufweist,
dadurch gekennzeichnet, daß die Bondspitze (11) mindestens eine erste (13) und eine zweite Drahthaltenut (14) unterschiedlicher Längen aufweist, welche die erste bzw. die zweite Bondfläche definieren, von denen die zweite Drahthaltenut (14) an einem Ende durch einen Vorsprung (15) geschlossen ist, um den Draht einzukerben und das Abbrechen des Drahts nach dem Bonden zu erleichtern.

4. Werkzeugkopf nach Anspruch 3,
**dadurch gekennzeichnet**, daß die Nuten (13, 14) parallel zueinander entlang dem Arbeitsende (12) verlaufen.

5. Werkzeugkopf nach Anspruch 3,
**dadurch gekennzeichnet**, daß die erste (13) der Nuten annähernd ein Drittel bis die Hälfte länger ist als die zweite (14) der Nuten.

6. Werkzeugkopf nach Anspruch 3,
**dadurch gekennzeichnet**, daß die Nuten (13, 14) im wesentlichen V-förmig mit einem Öffnungswinkel von etwa 60° in einem Querschnitt senkrecht zur Länge der Nuten sind.

7. Werkzeugkopf nach Anspruch 3,
**dadurch gekennzeichnet**, daß die erste Nut (13) eine im wesentlichen geradlinige Profilgestalt (16) mit gekrümmten, einander abgewandten Enden (17) aufweist, wobei die einander abgewandten Enden (17) eine Biegung aufweisen, die zur Mitte der Bondspitze (11) gerichtet ist, betrachtet in einem Querschnitt parallel zur Länge der Nut.

## Revendications

1. Procédé pour connecter des fils conducteurs (7) entre une puce (1) semi-conductrice de circuit et des connecteurs correspondants (5) comprenant les étapes suivantes:
prévoir une tête de fixation (9) comprenant une pointe de fixation (11) ayant une extrémité de travail (12) présentant au moins deux rainures (13, 14) de longueurs différentes, définissant au moins une première et une seconde surfaces de fixation ayant différentes zones et recevant lesdits fils conducteurs (7) ;
- maintenir une extrémité du fil (7) sur le connecteur (5) dans une première (13) desdites rainures, et la fixer ;
- maintenir l'autre extrémité dudit fil sur la puce (1) dans la seconde (14) desdites rainures, et la fixer; et
- faire une encoche dans ladite autre extrémité du fil (7) au moyen d'un ergot en saillie (15) fermant une extrémité de la seconde (14) desdites rainures, pour faciliter la cassure du fil après sa fixation.

2. Procédé selon la revendication 1, caractérisé en ce que ladite première rainure (13) est plus longue que ladite seconde rainure (14).

3. Tête de fixation pour un équipement utilisé en un mode de fixation par piquage pour fixer des fils conducteurs (7) s'étendant entre une puce (1) semi-conductrice de circuit et des connecteurs (5) d'extrémité correspondants, comprenant une pointe de fixation (11) ayant une extrémité de travail (12) présentant au moins une première et une seconde surfaces de fixation ayant différentes zones, caractérisée en ce que ladite pointe de fixation (11) comprend au moins une première (13) et une seconde rainures (14) de maintien du fil ayant des longueurs différentes et définissant lesdites première et seconde surfaces de fixation, la seconde rainure (14) de maintien du fil étant fermée à une extrémité par un ergot en saillie (15) pour faire une encoche dans ledit fil et faciliter la cassure du fil après sa fixation.

4. Tête d'outil selon la revendication 3, caractérisée en ce que lesdites rainures (13, 14) sont parallèles le long de ladite extrémité de travail (12).

5. Tête d'outil selon la revendication 3, caractérisée en ce que la première (13) desdites rainures dépasse en longueur la seconde (14) desdites rainures d'environ un tiers à une moitié.

6. Tête d'outil selon la revendication 3, caractérisée en ce que lesdites rainures (13, 14) ont sensiblement un profil en V avec un angle d'ouverture de soixante degrés environ, sur une section transversale perpendiculaire à la longueur des rainures.

7. Tête d'outil selon la revendication 3, caractérisée en ce que la première rainure (13) a sensiblement une forme rectiligne (16) avec des extrémités opposées cintrées (17), lesdites extrémités (17) ayant une courbure orientée vers le centre de la pointe de fixation (11) sur une section droite parallèle à la longueur de la rainure.
